Europäisches Patentamt

European Patent Office

Office européen des brevets

(19)

(11) Numéro de publication : **0 064 003**
**B1**

## (12) FASCICULE DE BREVET EUROPÉEN

(45) Date de publication du fascicule du brevet :
20.02.85

(51) Int. Cl.⁴ : **H 01 J 37/305, H 01 J 37/24**

(21) Numéro de dépôt : **82400708.2**

(22) Date de dépôt : **20.04.82**

(54) **Dispositif de traitement d'un échantillon par faisceau électronique impulsionnel.**

(30) Priorité : 28.04.81 FR 8108449

(43) Date de publication de la demande :
03.11.82 Bulletin 82/44

(45) Mention de la délivrance du brevet :
20.02.85 Bulletin 85/08

(84) Etats contractants désignés :
CH DE GB IT LI NL

(56) Documents cités :
US-A- 4 082 958
JOURNAL OF THE ELECTROCHEMICAL SOCIETY;
vol. 128, no. 9, septembre 1981, MANCHESTER, NEW
HAMPSHIRE (US) T. ITOH et al.: "Pulsed E-B Apparatus and Annealing of Ion-Implanted Silicon", pages
2032-2034
JOURNAL OF APPLIED PHYSICS, vol. 50, no. 2,
février 1979, American Institute of Physics, NEW
YORK (US) A.C. GREENWALD et al.: "Pulsed-elec-
tron-beam annealing of ion-implantation damage",
pages 783-787
SOLID STATE TECHNOLOGY, vol. 22, no. 4, avril 1979
NEW YORK (US) A.C. GREENWALD et al.: "Pulsed
electron-Beam Processing of Semiconductor Devices", pages 143-148

(73) Titulaire : **COMMISSARIAT A L'ENERGIE ATOMIQUE**
**Etablissement de Caractère Scientifique Technique**
**et Industriel**
**31/33, rue de la Fédération**
**F-75015 Paris (FR)**

(72) Inventeur : **Bruel, Michel**
**Presvert No 9**
**F-38113 Veurey (FR)**
Inventeur : **Floccari, Michel**
**Décédé (FR)**
Inventeur : **Michaud, Jean-François**
**Saint Pierre de Soucy**
**F-73800 Montmelian (FR)**

(74) Mandataire : **Mongrédien, André et al**
**c/o BREVATOME 25, rue de Ponthieu**
**F-75008 Paris (FR)**

Jouve, 18, rue St-Denis, 75001 Paris, France

## Description

La présente invention a pour objet un dispositif de traitement d'un échantillon par faisceau électronique impulsionnel. Elle s'applique en particulier dans le traitement des couches superficielles des matériaux semiconducteurs.

En effet, lorsque l'on implante par exemple dans un substrat semiconducteur, en effectuant un bombardement de celui-ci, des particules étrangères ou impuretés, on sait qu'il est nécessaire d'effectuer, après cette implantation, une étape connue sous le mot de recuit permettant de rendre électriquement actives les impuretés implantées et permettant de ré-arranger le réseau cristallin du substrat qui a été perturbé lors du bombardement.

L'une des techniques les plus utilisées pour effectuer cette étape de recuit consiste à porter le substrat implanté à une température élevée (de l'ordre de 900 à 1 200 °C) pendant un certain temps.

Une autre technique, plus récente, consiste à apporter à la surface, ou au niveau des premières couches implantées, une densité d'énergie élevée, pendant un temps très bref, de façon que de très hautes températures soient atteintes localement pendant ce temps. Dans certains cas, les températures atteintes permettent de liquéfier les premières couches du substrat, ce qui permet de guérir les dommages créés lors de l'implantation.

Etant donné que l'élévation de température est très localisée et de courte durée (inférieure à la milliseconde), le reste du substrat n'est pas affecté.

Cet apport d'énergie à la surface ou sur les premières couches du substrat peut être réalisé, soit à l'aide d'un tir d'énergie lumineuse au moyen, par exemple d'un laser ou d'un tube éclair, soit à l'aide d'un faisceau intense de particules telles que des électrons. Ces faisceaux lumineux ou de particules peuvent être des faisceaux larges ou étroits, pulsés ou non, et peuvent balayer le substrat de façon à « recuire » celui-ci en différents points.

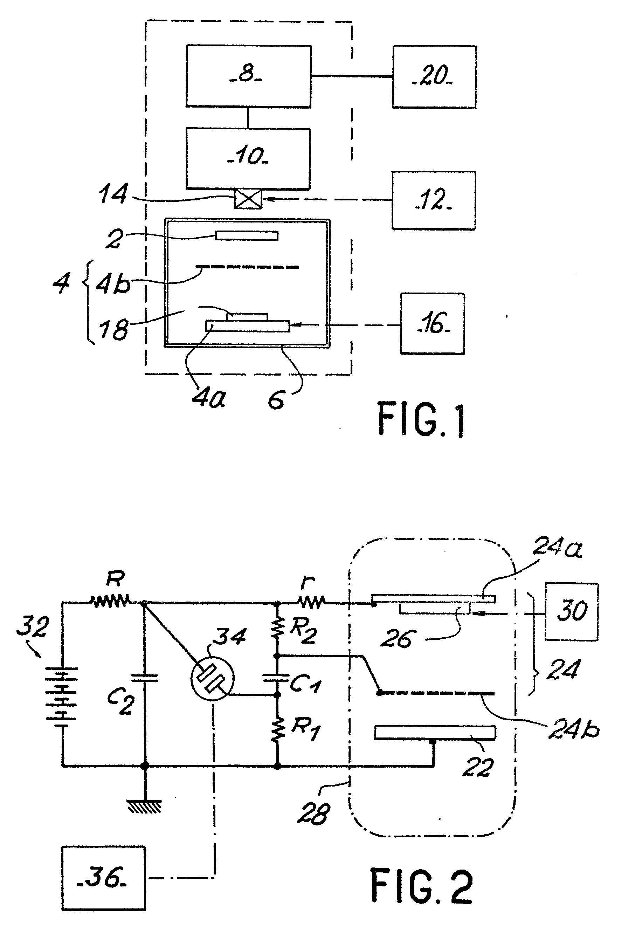

Les dispositifs connus pour traiter des échantillons, au moyen d'un faisceau d'électrons intenses et pulsés, comprennent, en général une diode d'émission de champ et de plasma connue sous l'expression anglo-saxonne de « field-plasma emission diode ». Un tel dispositif a été représenté sur la figure 1.

Ce dispositif comprend donc, une diode constituée d'une cathode 2, généralement en graphite et munie de plusieurs sillons, et d'une anode 4 constituée d'une anode proprement dite 4a et d'une grille 4b, ces deux éléments 4a et 4b étant portés au même potentiel. Cette diode est généralement placée dans une enceinte à vide 6.

De plus, ces dispositifs comprennent un générateur de haute tension 8, relié à un système de stockage d'énergie sous haute tension 10 pouvant être constitué par exemple d'une ligne coaxiale ou d'un condensateur, ainsi qu'un système 12 de déclenchement d'impulsions, relié à un interrupteur 14, par exemple du type éclateur connu sous l'expression anglo-saxonne de « Spark gap switch ». Ces dispositifs comprennent, encore, un système d'amenée 16 permettant de présenter les échantillons à traiter 18 dans l'enceinte à vide 6, et des systèmes 20 permettant de mesurer la tension et le courant fournis par le générateur 8 au cours du temps. L'anode proprement dite 4a sert de support à l'échantillon 18.

De tels dispositifs ont été décrits, par exemple dans le brevet américain N° 3 950 187 et dans l'article du « Journal of Applied Physics », vol. 50, n° 2 de février 1979 intitulé « Pulsed-electron-beam annealing of ion implantation damage ».

Dans ces dispositifs, l'application d'une tension importante entre la grille 4b de l'anode et la cathode 2 au moyen par exemple d'un condensateur 10, chargé au préalable par le générateur 8, permet de créer un champ électrique intense au voisinage de la cathode 2 de la diode. L'application de la tension de charge du condensateur 10 est assurée au moyen de l'éclateur 14 commandé par le système de déclenchement d'impulsions 12.

Le champ électrique créé est intensifié au voisinage de la cathode par la présence de microprotubérances, connues sous le mot anglo-saxon de « whiskers », provenant des sillons (non représentés) dont est munie la cathode. La puissance électrique ainsi fournie est telle que l'on assiste à une explosion de ces microprotubérances correspondant à une vaporisation explosive et à une ionisation de celles-ci. Les microboules de plasma ainsi formées deviennent à leur tour une source d'électrons favorisant l'augmentation rapide du courant qui favorise elle-même l'explosion. En quelques nanosecondes, chacune de ces microboules de plasma s'étend suffisamment pour que la cathode soit recouverte d'une gaine de plasma continue. Cette gaine voit alors, par effet de détente, son épaisseur augmenter jusqu'à ce qu'elle atteigne la grille de l'anode, produisant un court-circuit de la diode connue sous l'expression anglo-saxonne de « diode-closure ».

Le condensateur 10 chargé par le générateur 8, continue à se décharger dans la diode. La tension appliquée entre anode et cathode par le condensateur a permis, avant que n'intervienne le court-circuit, d'extraire et d'accélérer les électrons créés de façon à former un faisceau électronique intense et pulsé qui peut par exemple servir à recuire l'échantillon 18.

Le fait d'utiliser dans un tel dispositif une anode proprement dite 4a servant de support à l'échantillon 18, conduisant donc à polariser positivement ledit échantillon, permet aux électrons de pénétrer aisément dans celui-ci, tandis que les ions formés ne peuvent pas pénétrer dans l'échantillon, ceux-ci étant automatiquement repoussés. On obtient bien, ainsi, un faisceau d'électrons intense et pulsé.

En conséquence, le générateur de haute tension 8, par l'intermédiaire du condensateur 10, sert à la fois à la création de la gaine de plasma qui sera la source des électrons et à l'extraction et accélération de ces derniers.

De tels dispositifs permettent de créer des faisceaux d'électrons dont l'énergie est comprise entre 10 et 50 kiloélectronvolts (KeV), dont l'intensité est de 100 à quelques milliers d'ampères par centimètre carré et dont la durée des impulsions est de quelques dizaines de nanosecondes à quelques microsecondes.

Pour de plus amples détails sur le principe de fonctionnement de tels dispositifs, on peut se référer à l'article du « Journal of Applied Physics », vol. 45, N° 6 de juin 1974 intitulé « Plasma-induced field emission and the characteristics of high-current relativistic electron flow ».

Ces dispositifs, de conception simple présentent un certain nombre d'inconvénients. Ces inconvénients sont, en particulier :

— la nécessité d'engendrer brusquement une haute tension dans l'espace compris entre l'anode et la cathode dans des conditions telles que l'intensité doit être très importante, c'est-à-dire comprise entre 100 et 10 000 ampères ;

— les caractéristiques du faisceau d'électrons, c'est-à-dire son énergie et sa densité de courant ne peuvent pas être choisies indépendamment des conditions dans lesquelles est engendré le plasma. Par exemple, si l'on désire obtenir un faisceau d'électrons de faible énergie, c'est-à-dire de l'ordre de 20 KeV, il n'est pas évident que le champ électrique correspondant suffira à engendrer la gaine de plasma ;

— l'utilisation d'un système à très forte puissance pour engendrer le plasma, alors que la création de celui-ci ne l'exige pas.

L'invention a justement pour objet un dispositif de traitement d'un échantillon par faisceau électronique impulsionnel permettant de remédier à ces différents inconvénients.

Le dispositif de l'invention, basé sur les mêmes principes que ceux décrits précédemment, permet de séparer les deux fonctions suivantes :

— la création de la gaine de plasma, et

— l'extraction et l'accélération des électrons créés, et utilise à cet effet les moyens mentionnés dans la revendication principale.

De façon plus précise, l'invention a pour objet un dispositif de traitement d'un échantillon par faisceau électronique du genre de ceux décrits précédemment, mais dans lequel le tube à vide comporte trois électrodes indépendantes. Ce dispositif se caractérise en ce qu'il comprend, de plus :

A) Un premier circuit pour créer de façon impulsionnelle un plasma à partir de la cathode du tube à vide, ce premier circuit comprenant :

a) un condensateur de capacité $C_1$ chargé au moyen du générateur de haute tension continue, ledit condensateur étant muni d'une première et d'une deuxième armatures,

b) un éclateur permettant d'initier la décharge du condensateur de capacité $C_1$ de façon à produire une impulsion de haute tension entre la cathode et la grille, ledit éclateur étant disposé en série avec ledit condensateur, et

c) des moyens pour engendrer des impulsions commandant l'éclateur ; et

B) Un deuxième circuit pour créer entre l'anode proprement dite et la cathode un champ électrique permettant d'accélérer et d'extraire les électrons produits de façon qu'ils viennent bombarder l'échantillon, ce deuxième circuit comprenant un condensateur de capacité $C_2$ très supérieure à la capacité $C_1$, ce condensateur de capacité $C_2$ étant chargé au moyen du générateur de haute tension continue et pouvant se décharger par le tube à vide lui-même.

Selon un mode de réalisation préféré de l'invention, le premier circuit comprend, de plus, deux résistances identiques $R_1$ et $R_2$, reliées en série avec le condensateur de capacité $C_1$, de façon que l'une des bornes de la résistance $R_1$ soit reliée à la première armature dudit condensateur et que l'une des bornes de la résistance $R_2$ soit reliée à la deuxième armature dudit condensateur, l'éclateur étant alors relié d'une part à la première armature du condensateur de capacité $C_1$ et, d'autre part, à l'autre borne de la résistance $R_2$, et il comprend également le condensateur de capacité $C_2$ branché en parallèle avec le circuit $R_1 C_1 R_2$.

Dans ce mode de réalisation, et du fait de la valeur élevée des résistances $R_1$ et $R_2$ par rapport à l'impédance du reste du premier circuit, la tension appliquée entre cathode et grille au moment du déclenchement de l'éclateur est la somme des tensions stockées dans les condensateurs de capacité $C_1$ et $C_2$, soit deux fois la tension du générateur de tension continue.

D'autres caractéristiques et avantages de l'invention ressortiront mieux de la description qui va suivre, donnée à titre explicatif mais nullement limitatif, en référence aux figures annexées dans lesquelles :

la figure 1, déjà décrite, représente schématiquement un dispositif de traitement d'échantillons de l'art antérieur, et

la figure 2 représente schématiquement un dispositif de traitement d'échantillons conforme à l'invention.

Le dispositif de l'invention, schématisé sur la figure 2, comprend entre autres un tube à décharge comportant, comme précédemment, une cathode 22 munie de plusieurs sillons (non représentés) et une anode 24 constituée d'une anode proprement dite 24a et d'une grille 24b. Ce tube permet la production de faisceaux d'électrons intenses et pulsés, susceptibles de bombarder un échantillon 26 placé sur l'anode proprement dite 24a qui lui sert de support. L'utilisation de l'anode proprement dite 24a en tant que support d'échantillon permet de polariser positivement celui-ci, ce qui produit la pénétration des électrons dans ledit échantillon et l'éloignement des ions aussi formés. Les électrodes et l'échantillon sont placés dans une enceinte à vide telle que 28. Des moyens 30 sont prévus pour amener à l'intérieur de l'enceinte 28 l'échantillon 26 à traiter.

Ce dispositif comprend, aussi, un générateur de haute tension continue 32 servant à charger sous une tension V un condensateur de capacité $C_1$ et un condensateur de capacité $C_2$ branchés en parallèle. Les capacités $C_1$ et $C_2$ sont telles que la capacité $C_2$ est très supérieure à la capacité $C_1$, c'est-à-dire que la capacité $C_2$ est de 10 à 50 fois plus grande que la capacité $C_1$.

Le condensateur de capacité $C_1$ est, de plus, relié en série avec deux résistances identiques $R_1$ et $R_2$, situées de part et d'autre dudit condensateur. En effet, la résistance $R_1$ a l'une de ses bornes connectée à la masse et l'autre borne à l'une des armatures du condensateur de capacité $C_1$, tandis que la résistance $R_2$ a l'une de ses bornes connectée à la borne positive du générateur haute tension 32 et l'autre borne à l'autre armature dudit condensateur.

De plus, l'ensemble constitué des deux résistances $R_1$ et $R_2$ et du condensateur de capacité $C_1$ peut être relié en série avec une résistance r et le condensateur de capacité $C_2$ peut être relié en série avec une résistance R. La résistance R est très supérieure à la résistance r, comme on le verra ci-après dans un exemple de réalisation.

Ce dispositif comprend, encore, un éclateur 34 commandé par un générateur d'impulsions 36. Cet éclateur 34 est relié d'une part à la borne positive du générateur haute tension 32 par l'intermédiaire de la résistance R et d'autre part, à l'armature du condensateur de capacité $C_1$ reliée à la résistance $R_1$.

Dans le dispositif de l'invention, la cathode 22 de la diode est reliée à la masse, la grille 24b de l'anode est reliée à la borne de la résistance $R_2$ qui est reliée à l'une des armatures du condensateur de capacité $C_1$, et l'anode proprement dite 24a à l'autre borne de la résistance $R_2$ par l'intermédiaire de la résistance r.

Le circuit comprenant principalement le condensateur de capacité $C_1$, le condensateur de capacité $C_2$ et l'éclateur 34, commandé par le générateur d'impulsions 36, constitue un circuit de faible puissance ($C_1$ étant inférieur à $C_2$) permettant d'engendrer un plasma en créant une vaporisation et une ionisation au voisinage de la cathode 22. Le plasma est engendré par l'application aux bornes de l'espace grille-cathode de la somme des tensions stockées dans les condensateurs de capacités $C_1$ et $C_2$ sous la commande de l'éclateur 34.

Le circuit comprenant principalement le condensateur de capacité $C_2$ constitue un circuit de forte puissance permettant l'extraction et l'accélération des électrons produits en créant un champ électrique important entre l'anode proprement dite 24a et la cathode 22. Ce circuit, contrairement à ceux des dispositifs de l'art antérieur, ne comprend pas d'interrupteur ou d'éclateur, ce qui permet d'éviter les problèmes posés par la fermeture brusque du circuit de forte puissance.

Le dispositif de l'invention présente un autre avantage lié à l'indépendance des deux fonctions, c'est-à-dire d'une part la création du plasma et d'autre part, l'extraction et l'accélération des électrons. Ceci permet de choisir la tension d'extraction et d'accélération sans que cela n'ait d'incidence sur la création du plasma, la puissance nécessaire étant fonction de la tension fournie par le générateur de haute tension 32 et de la valeur de la capacité $C_2$ du condensateur correspondant.

Comme on l'a déjà dit, le fonctionnement du dispositif de l'invention est identique à celui de l'art antérieur, si ce n'est le fait que le circuit de forte puissance ne comprend pas d'interrupteur. De plus, l'utilisation des deux résistances identiques $R_1$ et $R_2$ d'impédance très élevée par rapport à celles de l'éclateur 34 et des capacités $C_1$ et $C_2$ permet d'obtenir, lorsque le générateur d'impulsions 36 déclenche l'éclateur 34 provoquant la décharge du condensateur de capacité $C_1$, une impulsion entre la grille 24b de l'anode et la cathode 22 de la diode, dont la tension est double de celle fournie par le générateur haute tension 32. Ceci est lié à l'agencement des différents composants constituant le circuit de faible puissance.

On va maintenant donner un exemple de réalisation ainsi que des exemples de traitement d'échantillons.

Le générateur haute tension permet de charger les condensateurs de capacités $C_1$ et $C_2$, respectivement de 1 et 40 nanofarads, sous une tension de 30 kilovolts. Les résistances R et r sont respectivement de 30 Mégohms ($M\Omega$) et $2\Omega$ et les résistances $R_1$ et $R_2$, de 300 $M\Omega$.

Des essais de traitement d'échantillons ont été réalisés sur des plaquettes de silicium sur une surface d'environ 2,5 cm de diamètre au moyen d'une diode dont la cathode, de forme circulaire, présentait un diamètre de 2,5 cm, dont la distance entre la cathode et la grille était de 4 à 6 mm et dont celle entre la grille et l'anode proprement dite était de 0 à 3,5 cm.

L'énergie apportée pour recuire ces plaquettes peut être contrôlée, au moyen de la tension d'accélération, elle-même contrôlée, et au moyen de la distance entre l'anode proprement dite et la grille. Cette distance permet aussi de contrôler la durée de l'impulsion. De plus, l'énergie apportée dépend de la nature de la cathode. En effet, la nature de la cathode permet de contrôler la nature du plasma, donc la vitesse d'expansion, donc la durée des impulsions et donc de l'énergie apportée.

Les essais ont été réalisés avec des cathodes de graphite, d'aluminium, d'antimoine et de silicium, correspondant respectivement à une vitesse d'expansion de 3 cm/$\mu$s, de 2 cm/$\mu$s, de 1 cm/$\mu$s et de 2 cm/$\mu$s.

Les exemples de traitement d'échantillons décrits ci-dessus concernent un recuit d'échantillons ayant subi au préalable une implantation d'ions, mais bien entendu tout autre type de traitement peut être envisagé.

D'autre part on peut, sans sortir du cadre de l'invention, proposer des schémas différents de celui qui a été décrit ; par exemple le circuit de déclenchement apte à créer le plasma entre cathode et grille, circuit à faible puissance, et le circuit d'accélération des électrons vers l'anode, circuit à forte puissance, peuvent être indépendants, comporter des générateurs haute tension distincts et/ou des interrupteurs distincts.

## Revendications

1. Dispositif de traitement d'un échantillon par faisceau électronique impulsionnel du genre de ceux qui comprennent situées dans une enceinte à vide (28) une cathode (22) et une anode (24) constituée d'une anode proprement dite (24a) et d'une grille (24b), des moyens (30) pour amener dans ladite enceinte l'échantillon (26) à traiter, un générateur de haute tension continue (32), et un circuit pour créer de façon impulsionnelle un plasma à partir de la cathode, caractérisé en ce qu'il comprend un deuxième circuit pour créer entre l'anode proprement dite (24a) et la cathode (22) un champ électrique permettant d'accélérer et d'extraire les électrons produits de façon qu'ils viennent bombarder l'échantillon (26).

2. Dispositif de traitement selon la revendication 1, caractérisé en ce que ledit premier circuit comprend :

a) un condensateur de capacité $C_1$ chargé au moyen du générateur de haute tension continue (32), ledit condensateur étant muni d'une première et d'une deuxième armatures,

b) un éclateur (34) permettant d'initier la décharge du condensateur de capacité $C_1$ de façon à produire une impulsion de haute tension entre la cathode (22) et la grille (24b), ledit éclateur étant disposé en série avec ledit condensateur,

c) des moyens pour engendrer des impulsions commandant l'éclateur (34).

3. Dispositif de traitement selon l'une au moins des revendications 1 et 2, caractérisé en ce que ledit deuxième circuit comprend un condensateur de capacité $C_2$ très supérieure à la capacité $C_1$, ce condensateur $C_2$ étant chargé par un générateur de tension continue (32) et pouvant se décharger par le tube à vide lui-même, de façon à produire entre l'anode et la cathode ledit champ électrique.

4. Dispositif de traitement selon la revendication 3, caractérisé en ce que le premier circuit comprend, de plus, deux résistances $R_1$ et $R_2$, reliées en série avec le condensateur de capacité $C_1$ de façon que l'une des bornes de la résistance $R_1$ soit reliée à la première armature dudit condensateur et que l'une des bornes de la résistance $R_2$ soit reliée à la deuxième armature dudit condensateur, l'éclateur (34) étant, alors, relié d'une part à la première armature du condensateur de capacité $C_1$ et, d'autre part, à l'autre borne de la résistance $R_2$ et il comprend également le condensateur de capacité $C_2$ branché en parallèle avec le circuit $R_1 C_1 R_2$.

## Claims

1. Apparatus for the treatment of a sample by a pulsed electron beam of the type which comprises, located in a vacuum chamber (28), a cathode (22) and an anode (24), constituted by an anode proper (24a) and a grid (24b), means for introducing the sample (26) to be treated into said chamber, a continuous high tension generator (32) and a circuit for producing a plasma from the cathode in a pulsed manner, characterized in that it comprises a second circuit for producing between the anode proper (24a) and the cathode (22), an electric field to accelerate and separate the electrons produced so that they bombard the sample (26).

2. Treatment apparatus according to Claim 1, characterized in that said first circuit comprises :

a) a condenser of capacity $C_1$ loaded by means of a continuous high tension generator (32), said condenser having first and second plates,

b) a spark gap switch (34) stimulating discharge of the condenser of capacity $C_1$, whereby to produce a high tension pulse between the cathode (22) and the grid (24b), said spark gap switch being disposed in series with said condenser, and

c) pulse-generating means for controlling the spark gap switch (34).

3. Treatment apparatus according to either one of Claims 1 and 2, characterized in that said second circuit comprises a condenser of capacity $C_2$ greatly superior to the capacity $C_1$, said condenser $C_2$ being charged by a continuous tension generator (32) and able to discharge into the vacuum tube itself, whereby to produce said electric field between the anode and the cathode.

4. Treatment device according to Claim 3, characterized in that the first circuit additionally comprises two resistances $R_1$ and $R_2$, connected in series with the condenser of capacity $C_1$ whereby one of the terminals of resistance $R_1$ is connected to the first plate of said condenser, and in that one of the terminals of resistance $R_2$ is connected to the second plate of said condenser, the spark gap switch (34) thereby being connected on one hand to the first plate of the condenser of capacity $C_1$, and on the other hand to the other terminal of resistance $R_2$ and also comprising the condenser of $C_2$ branched in parallel with the circuit $R_1 C_1 R_2$.

## Ansprüche

1. Vorrichtung zur Probenbehandlung mittels gepulsten Elektronenstrahls, umfassend eine Kathode (22) und eine aus einer eigentlichen Anode (24a) und einem Gitter (24b) bestehenden Anode (24), die sich in einem Vakuumbehälter (28) befinden, Mittel (30), um die zu behandelnde Probe (26) in den Behälter einzubringen, einen Gleichhochspannungsgenerator (32) und einen Schaltkreis, um gepulst ein von der Kathode ausgehendes Plasma zu erzeugen, dadurch gekennzeichnet, daß ein zweiter Schaltkreis vorgesehen ist, um zwischen der eigentlichen Anode (24a) und der Kathode (22) ein elektrisches Feld zu erzeugen, durch welches erzeugte Elektronen beschleunigt und herausgezogen werden derart, daß sie die Probe (26) beschießen.

2. Vorrichtung zur Behandlung nach Anspruch 1, dadurch gekennzeichnet, daß der erste Schaltkreis umfaßt :

a) einen Kondensator mit der Kapazität $C_1$, der durch den Gleichhochspannungsgenerator (32) aufgeladen wird und einen ersten und einen zweiten Kondensatorbelag aufweist,

b) einen Entlader (34), mit dem die Entladung des Kondensators der Kapazität $C_1$ derart auslösbar ist, daß ein Hochspannungsimpuls zwischen der Kathode (22) und dem Gitter (24b) erzeugt wird, wobei der Entlader in Reihe mit dem Kondensator geschaltet ist,

c) Mittel zum Erzeugen von Impulsen zum Steuern des Entladers (34).

3. Vorrichtung zum Behandeln nach Anspruch 1 oder 2, dadurch gekennzeichnet, daß der zweite Schaltkreis einen Kondensator der Kapazität $C_2$ aufweist, die sehr viel größer als die Kapazität $C_1$ ist, wobei der Kondensator $C_2$ von einem Gleichspannungsgenerator (32) aufladbar ist und durch das Vakuumrohr selbst entladbar ist derart, daß zwischen der Anode und der Kathode das elektrische Feld erzeugt wird.

4. Vorrichtung zum Behandeln nach Anspruch 3, dadurch gekennzeichnet, daß der erste Schaltkreis ferner umfaßt zwei Widerstände $R_1$ und $R_2$, die in Reihe mit dem Kondensator der Kapazität $C_1$ derart geschaltet sind, daß einer der Anschlüsse des Widerstandes $R_1$ mit dem ersten Belag des Kondensators und einer der Anschlüsse des Widerstandes $R_2$ mit dem zweiten Belag des Kondensators verbunden ist, daß der Entlader (34) dann einerseits mit dem ersten Belag des Kondensators der Kapazität $C_1$ und andererseits mit dem anderen Anschluß des Widerstandes $R_2$ verbunden ist, und auch den Kondensator der Kapazität $C_2$ umfaßt, welcher parallel zu der Schaltungsanordnung $R_1$ $C_1$ $R_2$ geschaltet ist.

FIG.1

FIG.2

1